# FASCICULE DE BREVET EUROPEEN

(11) **EP 2 750 183 B1**
(45) Date de publication et mention de la délivrance du brevet: **22.04.2015**
(21) Numéro de dépôt: 13199245.5
(22) Date de dépôt: 20.12.2013
(51) Int. Cl.: H01L 23/34, H01L 23/38, H01L 23/498, H01L 27/02

(54) **Circuit intégré et procédé de fabrication d'un circuit intégré équipé d'une sonde de température**
Integrierter Schaltkreis, und Herstellungsverfahren eines integrierten Schaltkreises, der mit einer Temperatursonde ausgestattet ist
Integrated circuit and method for manufacturing an integrated circuit provided with a temperature probe

(30) Priorité: 26.12.2012 FR 1262813
(43) Date de publication de la demande: 02.07.2014
(73) Titulaire: Commissariat à l'Énergie Atomique et aux Énergies Alternatives, 75015 Paris (FR)
(72) Inventeur: Cheramy, Séverine, 38640 Claix (FR)
(74) Mandataire: GIE Innovation Competence Group

(56) Documents cités:
- DE-A1-102010 029 526
- FR-A1- 2 878 077
- US-A1- 2010 219 525

## Description

L'invention concerne un circuit intégré et un procédé de fabrication d'un circuit intégré équipé d'une sonde de température.

Les circuits intégrés comportent un substrat à la surface duquel et/ou à l'intérieur duquel sont réalisés des composants électroniques pour former une ou plusieurs puces électroniques.

Ces circuits intégrés sont réalisés en utilisant des procédés microélectroniques de fabrication collectifs. Par exemple, ces procédés mettent en oeuvre un usinage de substrat ou de couche par photolithographie et gravure (par exemple DRIE (Deep Reactive Ion Etching)) et/ou une structuration par croissance épitaxiale et dépôt de matériau conducteur. Grâce à ces procédés microélectroniques, les composants électroniques fabriqués sont petits et présentent généralement des dimensions d'ordre micrométrique ou nanométrique. La dimension d'ordre micrométrique ou nanométrique est généralement inférieure à 10 µm et, typiquement, inférieure à 1 µm.

Le substrat peut être homogène, c'est-à-dire massif, ou hétérogène, c'est-à-dire comportant plusieurs couches minces empilées. Dans ce cas, les composants électroniques sont réalisés à la surface et/ou à l'intérieur de ce substrat et la ou les puces électroniques sont disposées au moins en partie en surface de ce substrat.

Le substrat peut aussi être « multicouches », c'est-à-dire composé par un empilement de plusieurs substrats assemblés les uns au-dessus des autres. Les substrats empilés peuvent eux-mêmes être homogènes ou hétérogènes. Ici pour distinguer ce substrat des substrats empilés qui le compose, les substrats empilés sont appelés « couches ». Dans le cas d'un substrat multicouches, les couches empilées ne sont pas des couches minces. En particulier, chaque couche empilée présente une rigidité suffisante à elle seule pour être manipulée sans être collée sur un autre substrat. A cet effet, typiquement, les couches empilées présentent une épaisseur au moins dix ou cent fois supérieure à l'épaisseur des couches minces. Par exemple, les couches minces ont une épaisseur inférieure à 1 µm ou 0,1 µm alors que les couches empilées ont une épaisseur supérieure à 5 ou 10 ou 100 µm. Plusieurs de ces couches peuvent comporter des composants électroniques en surface au niveau de l'interface d'assemblage entre deux couches successives du substrat. Ces composants électroniques réalisés en surface des couches empilées constituent une ou plusieurs puces électroniques. Le circuit intégré comporte alors un empilement de plusieurs puces électroniques empilées les unes au-dessus des autres. Ces circuits intégrés dans lesquels plusieurs puces électroniques sont empilées l'une au-dessus de l'autre sont souvent appelés « circuit intégré 3D ».

Dans les circuits intégrés, l'un des principaux éléments qui limitent leur performance est la quantité de chaleur qu'ils produisent et qui doit être évacuée. Ce problème est encore plus important dans les circuits intégrés 3D.

Pour évaluer le plus correctement possible la chaleur d'un circuit intégré, il est utile de connaître les emplacements à l'intérieur de ce circuit intégré où la chaleur se concentre et atteint un maximum. Ces emplacements sont appelés « points chauds ». Il est important également de connaître la diffusion de ces points chauds à l'intérieur du circuit.

L'une des difficultés communément rencontrées est la connaissance de ces points chauds (emplacement et diffusion) et ce, d'autant plus qu'ils sont situés à l'intérieur du substrat et à un emplacement éloigné d'au moins 5 µm d'une face extérieure du substrat.

Or, on sait aujourd'hui mesurer la température à la surface du substrat mais pas à l'intérieur du substrat. Ainsi, actuellement, pour estimer la température d'un point chaud situé à l'intérieur du substrat, des logiciels de simulation sont utilisés. Ces logiciels sont basés sur des modèles mathématiques permettant de prédire l'écoulement des flux thermiques à l'intérieur du substrat. Pour améliorer l'estimation de ces logiciels, ceux-ci peuvent aussi utiliser en tant que données d'entrée les températures mesurées en surface du substrat. Toutefois, ces modèles peuvent s'avérer peu précis notamment pour estimer les aspects dynamiques de certains phénomènes thermiques.

De l'état de la technique est également connu de : FR2878077A1, DE102010029526A1 et US2010/219525A1.

L'invention vise à remédier à cet inconvénient en proposant un autre moyen pour mesurer la température à l'intérieur du substrat d'un circuit intégré.

Elle a donc pour objet un circuit intégré conforme à la revendication 1.

Dans le circuit intégré ci-dessus, puisque la jonction a un coefficient Seebeck supérieur à 1 µV/K à 20 °C, la différence de potentiels entre les premier et second plots de contact est fonction de la température de cette jonction ainsi que de la valeur de ce coefficient Seebeck. De plus, la jonction est enfouie à l'intérieur du substrat. La différence de potentiels entre les premier et les second plots de contact est donc représentative de la température sous la surface du substrat, c'est-à-dire de la température à l'intérieur du substrat et, plus précisément, de la température à l'emplacement de la jonction.

Les plots de contact étant en surface, la température à l'intérieur du substrat est facile à relever à partir de ces plots de contact. Ainsi, la température à l'intérieur du substrat du circuit intégré ci-dessus peut facilement être mesurée.

De plus, la jonction décrite ci-dessus est réalisable par les procédés microélectroniques de sorte qu'elle peut facilement être réalisée en même temps que le circuit intégré est fabriqué.

Les modes de réalisation de ce circuit intégré peuvent comporter une ou plusieurs des caractéristiques des revendications dépendantes.

Ces modes de réalisation du circuit intégré présentent en outre les avantages suivants :
- la réalisation de la jonction au fond d'un trou borgne est simple à réaliser par les procédés microélectroniques de fabrication;
- la réalisation de la jonction à l'emplacement où deux trous creusés à partir de faces extérieures opposées se rejoignent, est simple à réaliser par les procédés microélectroniques de fabrication et permet d'éviter la réalisation d'une couche isolante et interposée contre les premier et second cylindres des premier et second conducteurs électriques ;
- la réalisation de la jonction à partir de première et seconde pistes conductrices réalisées sur des faces de couches rapportées l'une sur l'autre permet de réaliser simplement une jonction située à l'intérieur du substrat ;
- chevaucher les extrémités des première et seconde pistes qui forment la jonction permet d'augmenter la surface de contact et d'accroître la sensibilité de la mesure de température ;
- utiliser des vias traversants pour raccorder la jonction aux plots situés sur une face extérieure du substrat permet d'enfouir plus profondément la jonction ;
- espacer les plots de contact d'au moins 50 µm par rapport à la jonction permet d'augmenter la précision de la mesure.

L'invention a également pour objet un procédé de fabrication d'un circuit intégré équipé d'une sonde de température conforme à la revendication 9.

Les modes de réalisation de ce procédé peuvent comporter une ou plusieurs des caractéristiques des revendications dépendantes de procédé.

L'invention sera mieux comprise à la lecture de la description qui va suivre, donnée uniquement à titre d'exemple non limitatif et faite en se référant aux dessins sur lesquels :
- la figure 1 est une illustration schématique en coupe verticale d'un premier mode de réalisation d'un circuit intégré,
- la figure 2 est une illustration schématique en vue de dessus du circuit intégré de la figure 1 ;
- la figure 3 est un organigramme d'un procédé de fabrication du circuit intégré de la figure 1 ;
- les figures 4 à 10 sont des illustrations schématiques en coupe verticale de différentes étapes de fabrication du circuit intégré de la figure 1 ;
- la figure 11 est une illustration schématique en coupe verticale d'un second mode de réalisation d'un circuit intégré ;
- la figure 12 est une illustration schématique en coupe verticale d'un troisième mode de réalisation d'un circuit intégré ;
- la figure 13 est un organigramme d'un procédé de fabrication du circuit intégré de la figure 12 ;
- la figure 14 est une illustration schématique en coupe verticale d'un quatrième mode de réalisation d'un circuit intégré ;
- la figure 15 est un organigramme d'un procédé de fabrication du circuit intégré de la figure 14 ;
- les figures 16 à 18 sont des illustrations schématiques en coupe verticale, respectivement, de cinquième, sixième et septième modes de réalisation d'un circuit intégré.

Dans ces figures, les mêmes références sont utilisées pour désigner les mêmes éléments.

Dans la suite de cette description, les caractéristiques et fonctions bien connues de l'homme du métier ne sont pas décrites en détail.

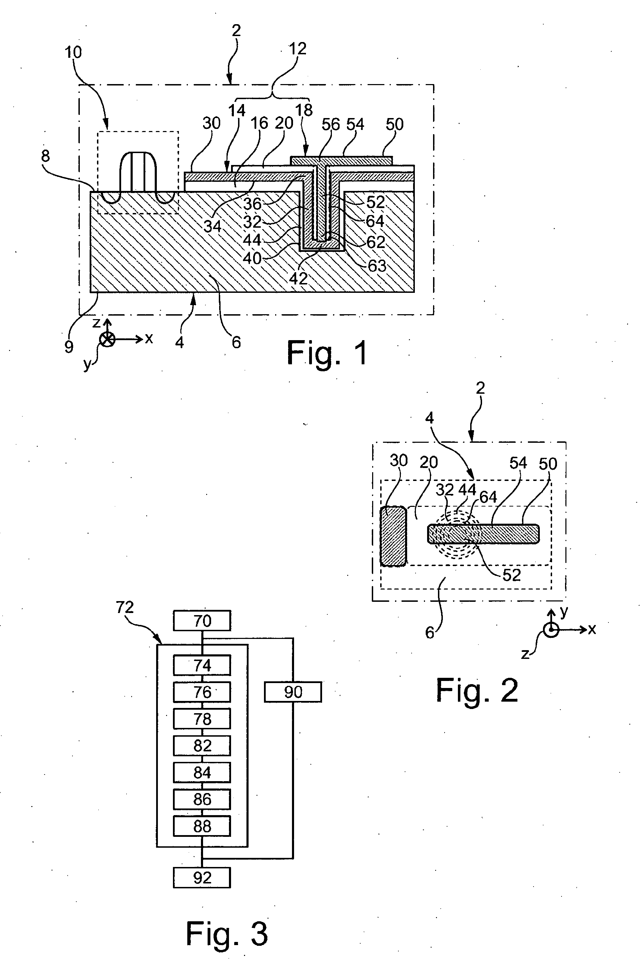

Les figures 1 et 2 représentent un circuit intégré 2. Ce circuit intégré 2 comporte une puce électronique 4 ou « Die » en anglais, encapsulée dans un boîtier électriquement isolant. Le boîtier protège la puce 4 des agressions de l'environnement extérieur.

Le circuit intégré 2 comporte aussi des bornes de raccordement électriques de la puce 4 à un circuit imprimé. Ces bornes de raccordement se matérialisent typiquement sous la forme de broches faisant saillie à l'extérieur du boîtier ou sous la forme de pastilles conductrices destinées à être soudées sur un circuit imprimé.

Pour simplifier les figures, dans cette demande de brevet :
- les bornes de raccordements et le boîtier ne sont pas représentés, et
- seule une portion de la puce est représentée.

La puce 4 comporte un substrat 6 homogène ou hétérogène s'étendant essentiellement dans un plan appelé « plan du substrat ». Ici, le plan du substrat s'étend horizontalement et parallèlement à des directions orthogonales X et Y. La direction verticale est représentée par une direction Z, perpendiculaire aux directions X et Y. Dans la suite de cette description, les termes « supérieur », « inférieur », « dessus » et « dessous » sont définis par rapport à cette direction Z.

La puce électronique 4 comporte également des composants électroniques réalisés sur une face horizontale supérieure 8 du substrat 6. Le substrat 6 comporte également une face horizontale inférieure 9 située du côté opposé à la face 8. Les faces 8 et 9 sont des faces extérieures du substrat 6, c'est-à-dire qu'elles délimitent le pourtour extérieur du substrat 6.

Ici, on a choisi de représenter par soucis de simplification, le substrat 6 comme un substrat massif. Son épaisseur est typiquement supérieure à 10 ou 100 ou 500 µm. Par exemple, le substrat 6 est en silicium.

Le circuit intégré 2 comporte un grand nombre de composants électroniques, par exemple, plus de 100 000 ou 10⁶ composants électroniques. Pour simplifier la figure 1, un seul composant électronique 10 est représenté sur cette figure. Sur la figure 2 et sur les figures suivantes, les composants électroniques ne sont pas représentés. Bien entendu le composant 10 représenté est très simplifié. De plus, il est représenté à une échelle qui ne correspond pas à celle du reste du circuit et notamment de la jonction électrique décrite plus loin.

Le composant électronique 10 est par exemple un composant électronique actif. Un composant électronique actif est défini comme étant un composant électronique qui permet d'augmenter la puissance d'un signal, par exemple la tension ou le courant ou les deux. La puissance supplémentaire est récupérée au travers d'une alimentation. Il s'agit typiquement de composants réalisés à partir de semiconducteurs tels que des transistors ou des thyristors. A l'inverse, un composant électronique passif est défini comme ne permettant pas d'accroître la puissance d'un signal. Il s'agit typiquement d'une résistance, d'un condensateur, d'une inductance ou d'une bobine ou encore d'une diode ou de tout assemblage de ces composants.

Ici, le composant 10 est un transistor tel qu'un transistor CMOS (« Complementary Metal Oxide Semiconductor »). Par exemple, le canal, le drain et la source de ce composant 10 sont directement implantés dans la surface 8 par dopage.

Le circuit intégré comprend également une sonde 12 de température permettant de mesurer la température à l'intérieur du substrat 6. Ici, par « intérieur du substrat 6 », on désigne un emplacement situé à plus de 5 µm de profondeur et de préférence à plus de 10 ou 20 µm de profondeur, à l'intérieur du substrat 6. Autrement dit, cet emplacement est à au moins d micromètres de toute face extérieure du substrat, où d est supérieur ou égal à 5 µm et typiquement supérieur ou égal à 10 µm ou 20 µm.

La sonde 12 comporte :
- un conducteur électrique 14 réalisé dans un premier matériau conducteur,
- une couche isolante 16 isolant électriquement le conducteur 14 du substrat 6,
- un conducteur électrique 18 réalisé dans un second matériau conducteur, et
- une couche isolante 20 isolant électriquement le conducteur 18 du conducteur 14.

Ici, on considère qu'un matériau est conducteur si sa résistivité à 20 °C est inférieure à 10⁻⁵ ou 10⁻⁶ Ω.m. A l'inverse, un matériau ou une couche est considéré comme étant électriquement isolant si sa résistivité à 20 °C est supérieure à 10⁵ ou 10⁶ Ω.m.

Le conducteur électrique 14 comporte un plot de contact 30 horizontal et un prolongement vertical 32 qui s'enfonce à l'intérieur du substrat 6. Le plot 30 est accessible depuis l'extérieur de la puce 4. A cet effet, par exemple, il n'est pas recouvert de la couche isolante 20. Ici, ce plot 30 est formé par une extrémité d'une piste électrique 34 horizontale entièrement déposée sur la couche isolante 16. La piste 34 se poursuit horizontalement entre les couches isolantes 16 et 20 pour raccorder électriquement une extrémité supérieure 36 du prolongement 32 au plot 30 de contact. L'extrémité supérieure 36 du prolongement 32 affleure à la surface de la couche isolante 16. La plus petite distance qui sépare le plot 30 de l'extrémité supérieure 36 est de préférence supérieure à 50 ou 100 µm. Ici, la piste 34 se poursuit horizontalement entre les conducteurs 16 et 20 tout autour de l'extrémité supérieure 36.

Le plot 32 est un cylindre creux déposé à l'intérieur d'un trou borgne 40, directement creusé dans le substrat 6 depuis la face 8. Le trou 40 s'enfonce verticalement dans le substrat 6. Par exemple, sa section transversale est circulaire. La profondeur du trou 40 est choisie en fonction de l'emplacement à l'intérieur du substrat 6 où doit être mesurée la température. Cette profondeur est strictement supérieure à 5 µm et, de préférence, supérieure à 10 µm de manière à permettre une mesure de la température à l'intérieur du substrat 6.

Du côté opposé à l'extrémité supérieure 36, le prolongement 32 se termine par une extrémité distale 42 située à plus de 5 µm sous la face 8 du substrat 6.

Le prolongement 32 est isolé des parois intérieures du trou 40 par un revêtement isolant 44. Dans le trou 40, le revêtement 44 recouvre toutes les parois verticales et le fond du trou 40. Ici, le revêtement 44 ne forme qu'un seul bloc de matière avec la couche isolante 16.

Le conducteur électrique 18 comporte un plot 50 de contact horizontal et un prolongement vertical 52 qui s'enfonce à l'intérieur du substrat 6.

Le plot 50 de contact est accessible depuis l'extérieur de la puce 4. Ici, il est formé par l'extrémité d'une piste électrique 54 horizontale entièrement déposée sur la couche isolante 20, elle-même entièrement déposée sur la piste 34.

La piste 54 se poursuit depuis le plot 50 jusqu'à une extrémité supérieure 56 du prolongement 52. L'extrémité supérieure 56 affleure à la surface de la couche isolante 20. La plus petite distance qui sépare l'extrémité supérieure 56 du plot de contact 50 est supérieure à 50 µm ou 100 µm.

Ici, la piste 54 se poursuit de part et d'autre de l'extrémité supérieure 56.

Le prolongement 52 est un cylindre plein déposé à l'intérieur du cylindre creux formé par le prolongement 32. Du côté opposé à l'extrémité supérieure 56, le prolongement 52 se termine par une extrémité distale inférieure 62 située à plus de 5 µm sous la face 8 du substrat 6. L'extrémité 62 est directement en contact mécanique et électrique avec l'extrémité 42 pour former une jonction 63.

Le prolongement 52 est isolé électriquement du prolongement 32 de partout par un revêtement isolant 64, sauf entre les extrémités 42 et 62. Ici, le revêtement 64 forme un cylindre creux vertical interposé entre les prolongements 32 et 52. Ce revêtement 64 ne forme qu'un seul bloc de matière avec la couche isolante 20.

Ici, l'ensemble des éléments de chaque conducteur 14, 18 est réalisé dans le même matériau conducteur. Les matériaux des conducteurs 14 et 18 sont choisis de manière à ce que la jonction 63 présente un coefficient Seebeck dont la valeur absolue est supérieure à 1 µV/K à 20 °C et, de préférence, supérieure à 5 ou 10 µV/K à 20 °C.

Par exemple, les matériaux des conducteurs 14 et 18 sont choisis dans le tableau suivant pour obtenir l'un des types de jonction précisés dans ce tableau.

| **Type de jonction** | **Composition des premier/second matériaux** |
|---|---|
| **J** | Fer / Constantan (alliage nickel+cuivre) |
| **K** | Chromel (alliage nickel + chrome) / Alumel (alliage nickel + aluminium (5 %) + silicium) |
| **N** | nicrosil (alliage nickel + chrome (14 %) + silicium (1,5 %)) / nisil (alliage nickel + silicium (4,5%) + magnésium (0,1 %)) |
| **T** | Cuivre / Constantan (alliage cuivre + nickel) |
| **R** | Platine-Rhodium (13 %) / Platine |
| **S** | Platine-Rhodium (10 %) / Platine |

De préférence, le type de la jonction est le type T, J, K, ou N et avantageusement le type T car les matériaux impliqués dans cette jonction sont simples à mettre en forme avec les procédés microélectroniques standards.

Le fonctionnement du circuit intégré 2 est le suivant. La jonction 63 forme un thermocouple également appelé « soudure chaude ». Cette jonction 63 est à la température à mesurer. A cause de l'effet Seebeck, il apparaît une différence de potentiels entre les plots 30 et 50 qui est fonction de la température de la jonction 63. Ces plots sont suffisamment éloignés de la jonction 63 pour former une jonction de référence ou « soudure froide » car ces plots de contact sont à la même température. Par exemple, les plots 30, 50 sont à la température ambiante, ou maintenus à une température de référence telle que 0° C. La température de la jonction 63 peut être obtenue à l'aide de la relation suivante : Sab = (VB1 - VB2)/(TB1 - TJ1), où
- VB1 - VB2 est la différence de potentiels entre les plots 30 et 50,
- TB1 est la température des plots 30 et 50,
- TJ1 est la température de la jonction 63, et
- Sab est la valeur du coefficient Seebeck de la jonction 63.

Pour un couple de matériaux donnés, la valeur du coefficient Seebeck est connue.

La différence de potentiels entre les plots 30 et 50 est par exemple relevée avec un testeur sous pointe lors de la fabrication du circuit intégré ou par des composants électroniques du circuit intégré lui-même de manière à ce que le circuit intégré ait la capacité de traiter et d'utiliser la température mesurée. Dans un autre mode de réalisation, la différence de potentiels est transmise à l'extérieur du circuit intégré vers, par exemple, un circuit imprimé équipé de composants électroniques aptes à traiter cette information.

La fabrication du circuit intégré 2 va maintenant être décrite à l'aide du procédé de la figure 3 et des figures 4 à 10.

Le procédé débute par une étape 70 de fourniture de substrat 6.

Ensuite, lors d'une étape 72, les conducteurs 14 et 18 sont réalisés.

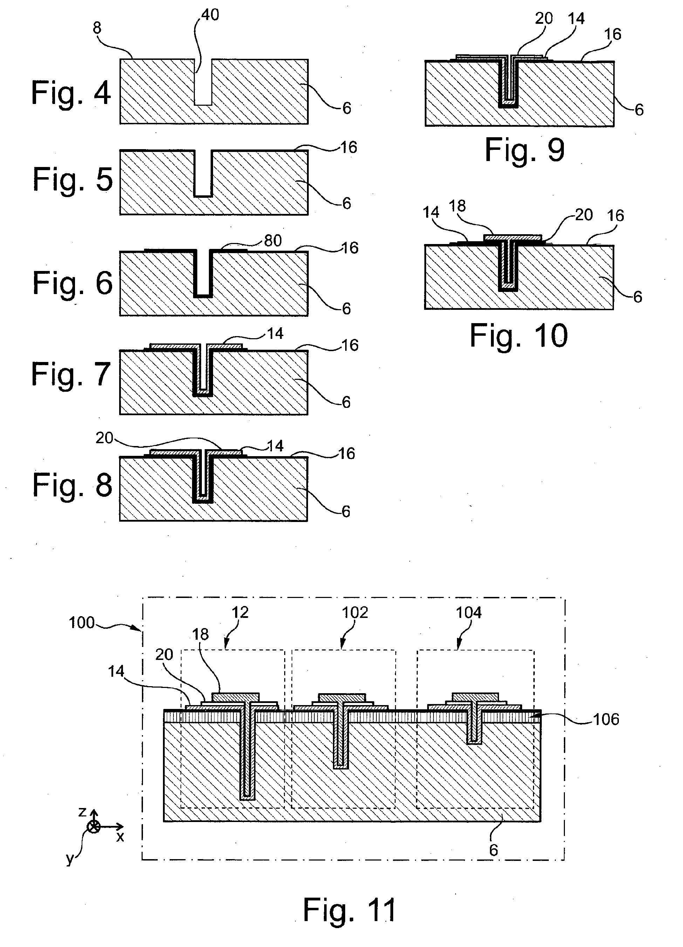

Cette étape 72 débute par une opération 74 de formation du trou borgne 40 depuis la face 8 (figure 4). Par exemple, le trou 40 est creusé par photolithographie, puis gravure profonde DRIE (Deep Reactive Ion Etching).

Lors d'une opération 76, une couche en matériau électriquement isolant telle que du SiO2 est déposée pour former en même temps la couche isolante 16 et le revêtement 44 (figure 5). Par exemple, le dépôt est réalisé par CVD (Chemical Vapor Deposition) ou PVD (Physical Vapor Deposition). L'épaisseur de la couche isolante déposée est typiquement supérieure à 10 nm et, généralement, inférieure à 5 µm.

Lors d'une opération 78, si nécessaire pour permettre l'accroche du matériau du conducteur 14, une couche d'accroche 80 est déposée sur la couche 16 et le revêtement 44 (figure 6). Par exemple, la couche d'accroche 80 est en titane ou en chrome.

Lors d'une opération 82, le conducteur 14 est déposé. Pour cela, une couche du matériau du conducteur 14 est déposée, puis mise en forme si nécessaire par photolithographie et gravure (figure 7). Par exemple, cette couche de matériau conducteur est déposée par PVD ou CVD ou ECD (« Electrochemical Deposition »). L'épaisseur de la couche conductrice est typiquement supérieure à 100 nm et, généralement, inférieure à 10 ou 20 µm.

Lors d'une opération 84, la couche isolante 20 et le revêtement 64 sont déposés (figure 8). Par exemple, cette opération 84 est réalisée de la même manière que l'opération 76.

Lors d'une opération 86, la couche isolante 20 déposée sur le fond du trou 40 est éliminée, par exemple, par gravure (figure 9) pour mettre à nu l'extrémité 42 du conducteur 14. Par exemple, la gravure est une gravure RIE (« Reactive Ion Etching »).

Lors d'une opération 88, une couche du matériau du conducteur 18 est déposée puis mise en forme (figure 10). Par exemple, cette opération est réalisée comme l'opération 82.

Avant l'étape 72, après l'étape 72 ou en parallèle de l'étape 72, lors d'une étape 90, les composants électroniques du circuit intégré tel que le composant électronique 10 sont fabriqués sur le substrat 6.

Après les étapes 72 et 90, lors d'une étape 92, le substrat 6 est découpé pour séparer les différentes puces 4 réalisées simultanément lors des étapes précédentes. Ensuite, chaque puce séparée est encapsulée dans un boîtier individuel équipé de broches ou de pastilles de raccordement.

La figure 11 représente un circuit intégré 100 identique au circuit intégré 2 sauf qu'il comporte en plus de la sonde 12 de température deux autres sondes 102 et 104 de température. De plus, dans le circuit intégré 100, les composants électroniques sont des transistors, par exemple des transistors MOS (« Metal Oxide Silicon »), implantés dans une couche active 106 dont la face extérieure correspond à la face supérieure 8 du substrat.

Les sondes 102 et 104 sont identiques à la sonde 12 sauf que les profondeurs où sont situées les jonctions des sondes 102 et 104 sont différentes de celle où est située la jonction 63. Cela permet de mesurer simultanément plusieurs températures à l'intérieur du substrat 6 à des profondeurs différentes. Pour cela, ici, seule la profondeur du trou 40 des sondes 102 et 104 diffère de la profondeur du trou 40 de la sonde 12. La section transversale des trous des sondes 102 et 104 est par exemple identique à la section transversale du trou 40 de la sonde 12.

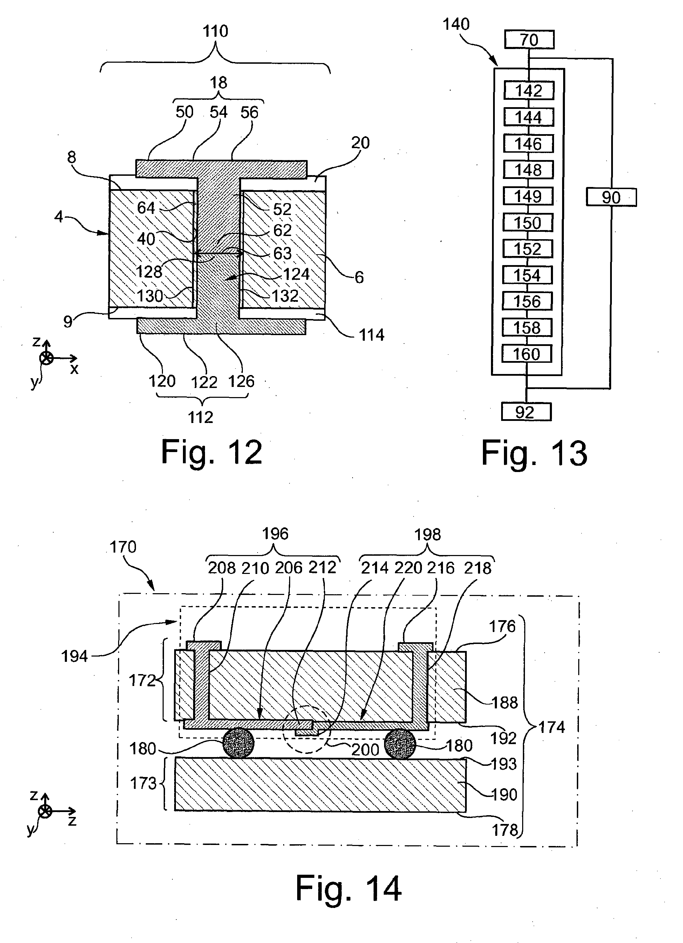

La figure 12 représente une sonde de température 110 utilisable en lieu et place de la sonde 12 pour mesurer la température à l'intérieur du substrat 6 de la puce 4. La sonde 110 est identique à la sonde 12 sauf que le conducteur électrique 14 et la couche isolante 16 sont remplacés, respectivement, par un conducteur électrique 112 et une couche isolante 114.

Dans le mode de réalisation de la figure 12, la jonction 63 est située à l'intérieur du substrat, par exemple à mi hauteur, entre les faces 8 et 9 du substrat 6. Dans ces conditions, le conducteur 112 et la couche 114 sont les symétriques, respectivement, du conducteur 18 et de la couche 20 par rapport à un plan horizontal passant par la jonction 63. Le prolongement 62 du conducteur 18 et le revêtement 64 remplissent entièrement le trou 40. Le conducteur 112 et la couche 114 sont, par exemple, réalisés dans les mêmes matériaux que, respectivement, le conducteur 14 et la couche 16. Dans ce mode de réalisation, le plot de contact, la piste électrique, le prolongement, les extrémités supérieure et inférieure de ce prolongement portent, respectivement, les références numériques 120, 122, 124, 126 et 128. Le trou, symétrique du trou 40, dans lequel est logé le prolongement 124, porte la référence 130. Enfin, le revêtement isolant électriquement le prolongement 124 du substrat 6 porte la référence 132. La jonction 63 est ici à l'emplacement où les extrémités 62 et 128 sont directement en contact mécanique et électrique l'une sur l'autre.

Le fonctionnement de cette sonde 110 se déduit du fonctionnement de la sonde 12 précédemment décrit.

La figure 13 représente un procédé de fabrication de la sonde 110. Ce procédé est identique au procédé de la figure 3, sauf que l'étape 72 est remplacée par une étape 140.

L'étape 140 débute par une opération 142 de formation du trou 40. Cette étape 142 est par exemple identique à l'étape 74.

Lors d'une opération 144, la couche 20 et le revêtement 64 sont déposés. Par exemple, il s'agit du dépôt d'une couche en SiO2 réalisé comme décrit en regard de l'opération 76.

Lors d'une opération 146, si nécessaire, une couche d'accroche est déposée. Cette opération est par exemple identique à l'opération 78.

Lors d'une opération 148, le conducteur électrique 18 est déposé. Cette opération est par exemple identique à l'opération 82, sauf que l'épaisseur de la couche du matériau conducteur déposée peut être différente. Par exemple, cette épaisseur est suffisante pour reboucher totalement le trou 40. Toutefois, reboucher totalement le trou 40 n'est pas obligatoire.

Lors d'une opération 149, la piste 54 est mise en forme, par exemple, par photolithographie et gravure.

Lors d'une opération 150, le trou 130 est formé depuis la face inférieure 9 du substrat. Cette opération 150 est, par exemple, identique à l'opération 142 sauf que le trou est creusé depuis la face 9.

Lors d'une opération 152, la couche isolante 114 et le revêtement 132 sont déposés. Par exemple, cette opération 152 est réalisée de la même manière que l'opération 144 mais dans le trou 130.

Lors d'une opération 154, seul le fond du trou 132 est gravé jusqu'à ce que l'extrémité 62 du prolongement 52 soit mise à nu. Par exemple, cette opération est réalisée à l'aide d'une gravure RIE.

Lors d'une opération 156, si nécessaire, une couche d'accroche est déposée. Cette opération 156 est par exemple réalisée comme l'opération 146.

Lors d'une opération 158, le conducteur 112 est déposé. Cette opération est par exemple réalisée comme l'opération 148.

Enfin, lors d'une opération 160, la piste 122 est mise en forme. Cette opération est par exemple réalisée comme l'opération 149.

La figure 14 représente un circuit intégré 170. Ce circuit intégré 170 comporte deux puces électroniques 172 et 173 empilées l'une au-dessus de l'autre et logées à l'intérieur d'un même boîtier équipé de broches ou de pastilles de raccordement.

Plus précisément, le circuit intégré 170 comporte un substrat 174 s'étendant essentiellement dans un plan horizontal. Le substrat 174 comporte une face supérieure 176 et une face inférieure 178 située du côté opposé. L'épaisseur du substrat 174 est par exemple la même que l'épaisseur du substrat 6.

Ici, le substrat 174 est un substrat multicouche, c'est-à-dire qu'il est réalisé par l'assemblage sans aucun degré de liberté les unes sur les autres de plusieurs couches dans la direction Z. Par exemple, les différentes couches sont assemblées les unes sur les autres à l'aide de billes fusibles telles que des billes 180 réalisées dans un alliage de brasage. Typiquement, l'alliage de brasage comporte de l'étain. Sur la figure 14, les billes 180 ne sont pas représentées à l'échelle. Ainsi, l'espace entre les différentes couches formant le substrat 174 est exagéré sur cette figure.

Pour simplifier la figure 14, seules deux couches horizontales 188 et 190 sont représentées. La face supérieure de la couche 188 correspond à la face 176. Une face inférieure 192 de cette couche 188 est tournée vers une face supérieure 193 de la couche 190. Ces faces 192 et 193 sont assemblées l'une sur l'autre sans aucun degré de liberté. Typiquement, des composants électroniques sont réalisés sur la face 193 pour former la puce 173. De même, les composants électroniques sont implantés dans la face 176 ou dans la face 192 pour former la puce électronique 172.

Par exemple, ces couches 188 et 190 sont en silicium.

Le circuit intégré 170 comporte également une sonde 194 de température permettant de mesurer la température à l'intérieur du substrat 6 au niveau de l'interface d'assemblage entre les couches 188 et 190. Cette sonde 194 comporte deux conducteurs électriques 196 et 198. Elle est électriquement isolée du substrat 174. Les conducteurs 196 et 198 sont électriquement isolés l'un de l'autre sauf au niveau d'une jonction électrique 200.

Pour simplifier la figure 14 et les figures suivantes, les couches isolantes et les revêtements isolants ne sont pas représentés.

Dans ce mode de réalisation, les extrémités des conducteurs 196 et 198 qui forment la jonction 200 sont réalisées dans les mêmes matériaux que, respectivement, les conducteurs 14 et 18.

Le conducteur 196 comporte :
- une piste électrique 206 réalisée sur la face 192,
- un plot 208 de contact réalisé sur la face extérieure 176 du substrat 174, et
- un prolongement 210 raccordant électriquement la piste 206 au plot 208.

Le plot 208 remplit la même fonction que le plot 30. A cet effet, par exemple, il est conformé de la même manière.

Le prolongement 210 traverse verticalement de part en part la couche 188 pour déboucher, d'un côté, sous le plot 208 et, du côté opposé, sous la piste 206. Typiquement, le prolongement 210 est un via également plus connu sous l'acronyme anglais TSV (« Through Silicon Via »).

La piste 206 s'étend horizontalement entre le prolongement 210 et une extrémité distale 212. L'extrémité distale 212 est en contact mécanique directement avec une extrémité distale correspondante 214 du conducteur électrique 198 pour former la jonction 200.

Dans ce mode de réalisation, le conducteur 198 est le symétrique du conducteur 196 par rapport à un plan vertical passant par la jonction 200 sauf au niveau de l'extrémité 214.

Sur la figure 14, le plot de contact, le prolongement, la piste électrique du conducteur électrique 198 portent, respectivement, les références numériques 216, 218 et 220.

L'extrémité 214 chevauche l'extrémité 212 dans la direction Z. Ainsi, elle recouvre l'extrémité 212. La surface de recouvrement est typiquement supérieure à 10 µm² et, de préférence, supérieure à 100 µm².

Le fonctionnement de la sonde 194 de température se déduit du fonctionnement de la sonde 12.

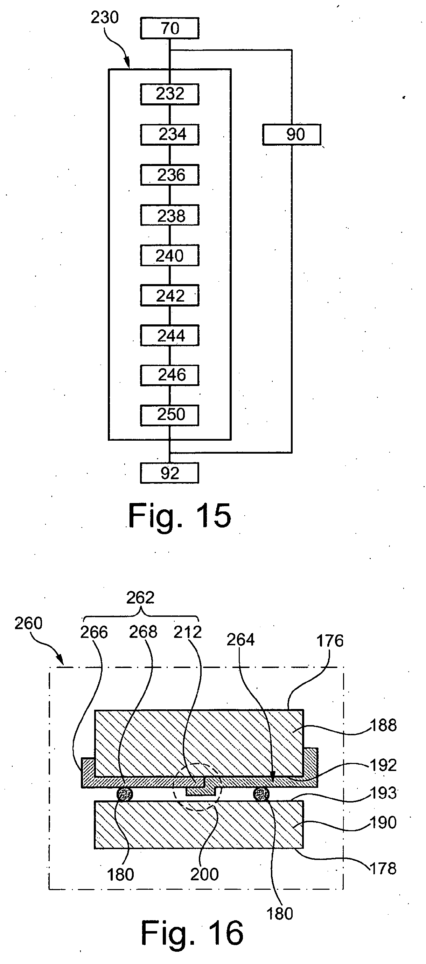

La figure 15 représente un procédé de fabrication du circuit intégré 170. Ce procédé de fabrication est identique à celui de la figure 3, sauf que l'étape 72 est remplacée par une étape 230.

L'étape 230 débute par une opération 232 de réalisation de trous traversants à l'emplacement des futurs prolongements 210 et 218. Par exemple, cette opération 232 est réalisée de la même manière que l'opération 74.

Lors d'une opération 234, si nécessaire, une couche isolante est déposée sur la face 176 et sur les parois intérieures des trous. Par exemple, cette opération est réalisée comme l'opération 76.

Lors d'une opération 236, si nécessaire, une couche d'accroche est déposée. Cette opération est par exemple réalisée de la même manière que l'opération 78.

Lors d'une opération 238, le matériau conducteur utilisé pour former le conducteur 196 est déposé puis mis en forme par photolithographie et gravure pour obtenir le plot 208 et le prolongement 210. Cette opération est par exemple réalisée de la même manière que l'opération 82.

Lors d'une opération 240, le matériau conducteur utilisé pour former le conducteur électrique 198 est déposé, puis mis en forme par photolithographie et gravure pour former le plot 216 et le prolongement 218. Cette opération est par exemple réalisée de la même manière que l'opération 88.

Lors d'une opération 242, une couche isolante est déposée sur la face 192. Cette opération 242 est par exemple réalisée de la même manière que l'opération 234.

Lors d'une opération 244, le matériau conducteur de la piste 206 est déposé puis mis en forme par photolithographie et gravure de manière à obtenir la piste 206. Cette opération est par exemple réalisée de la même manière que l'opération 238.

Lors d'une opération 246, le matériau conducteur de la piste 220 est déposé puis mis en forme pour obtenir cette piste 220. Cette opération est réalisée de la même manière que l'opération 244.

Enfin, lors d'une opération 250, la couche 188 est assemblée sur la couche 190 pour former le substrat 174 contenant la jonction 200 enfouie à l'intérieur de ce substrat au niveau de l'interface entre ces couches.

La figure 16 représente un circuit intégré 260. Ce circuit intégré 260 est identique au circuit intégré 170 sauf que les conducteurs électriques 196 et 198 sont remplacés, respectivement, par des conducteurs électriques 262 et 264.

Le conducteur électrique 262 est identique au conducteur 196 sauf que le plot 208 et la piste 206 sont remplacés, respectivement, par un plot 266 de contact latéral et une piste 268. De plus, le prolongement 210 est omis. Le plot 266 est réalisé sur un côté vertical de la couche 188.

La piste 268 est identique à la piste 206 sauf qu'elle se prolonge dans le plan horizontal pour déboucher sous le plot 266.

Le conducteur 264 est conformé comme le conducteur 262 pour présenter un plot de contact latéral.

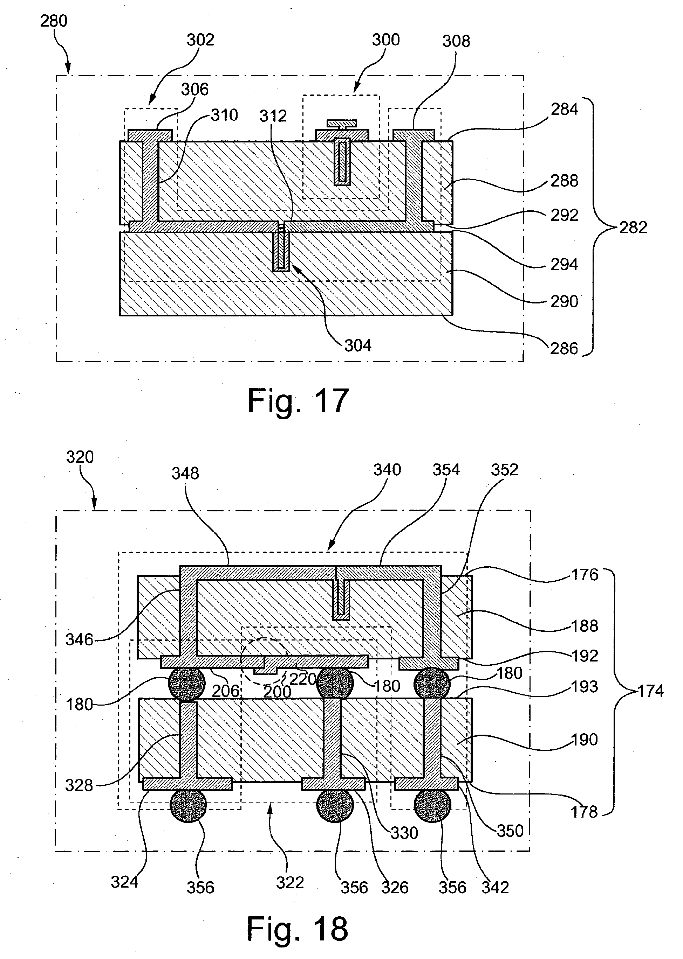

La figure 17 représente un circuit intégré 280. Ce circuit intégré 280 est identique au circuit intégré 2 sauf que le substrat 6 est remplacé par un substrat 282 multicouche présentant une face supérieure 284 et une face inférieure 286. Le substrat 282 comporte deux couches 288 et 290 empilées l'une sur l'autre. La face supérieure de la couche 288 correspond à la face 284 du substrat. Elle comporte également une face inférieure 292 tournée vers la couche 290. La face inférieure de la couche 290 correspond à la face inférieure 286 du substrat. Une face supérieure de la couche 290 porte la référence 294.

Le circuit intégré 280 comporte deux sondes 300 et 302 de température. La sonde 300 mesure la température à l'intérieur de la couche 288. Elle est par exemple réalisée comme la sonde 12 mais depuis la face supérieure 284.

La sonde 302 mesure la température à l'intérieur de la couche 290. Cette sonde 302 comporte une sonde 304 identique à la sonde 12, mais réalisée depuis la face supérieure 294 à l'intérieur de la couche 290. Elle comporte également :
- des plots 306 et 308 de contact sur la face extérieure 284, et
- des connexions électriques 310 et 312 qui s'étendent depuis les plots de contact 306, 308 jusqu'à la sonde 304 à travers la couche 288. Typiquement, ces connexions 310 et 312 sont des vias verticaux.

Cet agencement des sondes 300 et 302 permet de mesurer la température à l'intérieur d'un circuit intégré comportant un empilement de deux puces électroniques l'une sur l'autre. La première puce est réalisée dans la couche 288 et la seconde puce est réalisée dans la couche 290.

La figure 18 représente un circuit intégré 320 identique au circuit intégré 170 sauf que la sonde de température 194 est remplacée par une sonde 322 de température.

La sonde 322 est identique à la sonde 194, sauf que les plots de contacts 208 et 210 sont remplacés par des plots de contact 324 et 326 situés sur la face inférieure 178. Pour cela, des connexions 328 et 330 traversent de part en part la couche 190. Ici, ces connexions sont des vias. Une extrémité supérieure de ces vias est reliée aux pistes, respectivement, 206 et 220 par des billes fusibles 180.

Le circuit intégré 320 comporte également une sonde 340 de température pour mesurer la température à l'intérieur de la couche 188. Cette sonde 340 est réalisée dans la face 176 de la même manière que la sonde 12 du circuit intégré 2, sauf que ces plots 324 et 342 de contact sont réalisés sur la face inférieure 178 du substrat.

Dans ce mode de réalisation, le plot 324 est commun aux sondes 322 et 340. A cet effet, le plot 324 est électriquement raccordé à la jonction enfouie de la sonde 340 par l'intermédiaire de la piste 206, d'un via 346 traversant la couche 188 et d'une piste 348 horizontale réalisée sur la face 176.

Le plot 342 est électriquement raccordé à la jonction enfouie par :
- un via 350 traversant la couche 190,
- une bille fusible 180,
- un via 352 traversant la couche 188, et
- une piste horizontale 354 réalisée sur la face 176.

Les plots 324, 326 et 342 sont, par exemple, soudés à un circuit imprimé par l'intermédiaire de billes fusibles 356.

Dans ce mode de réalisation, la couche 390 sert à relier la couche 188 au circuit imprimé. Elle est alors connue sous le terme de « interposeur ».

De nombreux autres modes de réalisation sont possibles. Par exemple, le circuit intégré peut comporter des composants électroniques actifs ou passifs.

La jonction peut être placée à une profondeur quelconque souhaitée. Par exemple, dans le mode de réalisation de la figure 12, la jonction 63 n'est pas nécessairement à mi-distance entre les faces 8 et 9. En variante, elle est située plus près de la face 8 que de la face 9 ou vice versa. Dans ce cas, l'un des prolongements est raccourci, tandis que l'autre est allongé.

La section des prolongements formés par des cylindres qui s'enfoncent à l'intérieur du substrat peut être quelconque. En particulier, cette section horizontale peut être carrée ou rectangulaire. De plus, il n'est pas nécessaire que l'un des prolongements entoure l'autre. En variante, à l'intérieur du trou, les prolongements sont simplement juxtaposés sans qu'aucun de ces prolongements n'entoure l'autre.

De même, il n'est pas nécessaire que le prolongement 52 soit un cylindre plein. En variante, il peut aussi être un cylindre creux.

Les matériaux utilisés pour former la jonction ne sont pas nécessairement des métaux. Par exemple, la jonction peut être réalisée en dopant, un matériau semi-conducteur de façon différente de part et d'autre de la jonction. Typiquement, un même dopant sera utilisé pour réaliser les extrémités des conducteurs électriques, et ces extrémités diffèrent l'une de l'autre uniquement par la concentration en dopant.

Il n'est pas non plus nécessaire que chaque conducteur électrique soit entièrement réalisé dans le matériau conducteur utilisé pour former la jonction. En fait, seule l'extrémité de ce conducteur en contact mécanique avec l'extrémité de l'autre conducteur doit être dans ce matériau. Ainsi, en variante, à l'exception de l'extrémité, le reste du conducteur électrique est réalisé dans un autre matériau choisi pour que la jonction électrique entre cet autre matériau conducteur et l'extrémité du conducteur forment une jonction dont la valeur absolue du coefficient Seebeck est négligeable, c'est-à-dire inférieur à 0,5 µV/K et, de préférence, inférieure à 0,1 ou 0,01 µV/K à 20 °C. Par exemple, l'autre matériau est du cuivre situé, par exemple, dans les vias.

Le substrat contient généralement des éléments tels que des couches en matériau semi-conducteur. Toutefois, le matériau semi-conducteur n'est pas nécessairement du silicium. L'essentiel du substrat n'est pas non plus nécessairement réalisé en matériau semi-conducteur. Par exemple, l'essentiel du substrat peut être réalisé en verre ou en polymère.

Si le substrat est réalisé dans un matériau électriquement isolant, la réalisation des couches isolantes pour isoler les conducteurs électriques du substrat peut être omise.

Le substrat peut être homogène (massif) ou hétérogène (avec des couches minces) ou encore multicouche (empilement de substrats). Lorsque le substrat est multicouche, les différentes couches peuvent être assemblées les unes aux autres par d'autres moyens que la soudure. Par exemple, ces différentes couches peuvent être assemblées à l'aide d'une colle polymérique conductrice ou non, ou par collage direct sans apport de colle.

Le dépôt de la couche d'isolant entre les premier et second cylindres peut être réalisé après le dépôt des premier et second cylindres. Par exemple, à cet effet, dans un premier temps, à la place de la couche d'isolant, on dépose une couche sacrificielle. Dans un second temps, la couche sacrificielle est éliminée puis remplacée par une couche d'isolant.

Si les vias ont un diamètre hydraulique suffisamment important, le plot de contact peut être constitué par l'extrémité affleurante de ce via sur une face extérieure du substrat.

En variante, un trou borgne peut traverser plusieurs couches du substrat pour permettre de mesurer la température d'une puce électronique réalisée dans une couche enfouie depuis une face extérieure du substrat.

## Revendications

1. Circuit intégré comportant :
- un substrat (6 ; 174 ; 282) s'étendant essentiellement dans un plan appelé « plan du substrat »,
- au moins un composant électronique (10) réalisé à l'intérieur et/ou en surface du substrat,
- un premier conducteur électrique (14 ; 112 ; 196 ; 262) comportant un premier plot (30 ;120 ; 208 ; 266 ; 306 ; 324) de contact en surface du substrat et une première extrémité (42 ; 128 ; 212), le premier conducteur électrique étant électriquement isolé du substrat,
- un second conducteur électrique (18 ; 198 ; 264) comportant un second plot (50 ; 216 ; 308 ; 326, 342) de contact en surface du substrat et une seconde extrémité (62 ; 214), le second conducteur électrique étant électriquement isolé du substrat et électriquement isolé du premier conducteur électrique sauf au niveau de la seconde extrémité qui est mécaniquement et électriquement directement en contact avec la première extrémité pour former une jonction électrique (63 ; 200), ,
**caractérisé en ce que** les première (42 ; 128 ; 212) et seconde (62 ; 214) extrémités sont entièrement enfouies à au moins 5 µm de profondeur à l'intérieur du substrat et réalisées, respectivement, dans des premier et second matériaux différents choisis pour que la valeur absolue du coefficient Seebeck de la jonction soit supérieure à 1 µV/K à 20 °C de sorte que la combinaison de ces premier et second conducteurs forme une sonde de température.

2. Le circuit selon la revendication 1, dans lequel :
- les premier et second conducteurs électriques (14, 18) comportent, respectivement, des premier et second prolongements (32, 52) s'enfonçant à l'intérieur du substrat pour raccorder électriquement les première et seconde extrémités (42, 62), respectivement, aux premier et second plots de contact (30, 50), ces premier et second prolongements comportant, respectivement, un premier et un second cylindres disposés à l'intérieur d'un même trou borgne (40) d'au moins 5 µm de profondeur formés depuis une face du substrat, au moins les extrémités distales enfouies à l'intérieur du substrat des premier et second cylindres étant réalisées, respectivement, dans les premier et second matériaux pour former, respectivement, les première et seconde extrémités enfouies des premier et second conducteurs électriques, ces premier et second cylindres s'étendant à l'intérieur du trou depuis la face du substrat jusqu'à, respectivement, les première et seconde extrémités, et
- le circuit intégré comporte aussi au moins une couche d'isolant électrique (64) située partout entre les premier et second cylindres sauf entre les première et seconde extrémités.

3. Le circuit selon la revendication 1, dans lequel :
- les premier et second conducteurs électriques (18, 112) comportent, respectivement, des premier et second prolongements (52, 124) s'enfonçant à l'intérieur du substrat pour raccorder électriquement les première et seconde extrémités (62, 128), respectivement, aux premier et second plots de contact (50, 120),
- le premier prolongement (124) comportant un premier cylindre, dont au moins l'extrémité distale enfouie à l'intérieur du substrat est réalisée dans le premier matériau pour former la première extrémité (128) du premier conducteur électrique, ce premier cylindre s'étendant à l'intérieur d'un premier trou (130) formé depuis une première face du substrat jusqu'à la première extrémité,
- le second prolongement (52) comportant un second cylindre, dont au moins l'extrémité distale enfouie à l'intérieur du substrat est réalisée dans le second matériau pour former la seconde extrémité (62) du second conducteur électrique, ce second cylindre s'étendant à l'intérieur d'un second trou (40) jusqu'à la seconde extrémité (62), ce second trou étant formé depuis une seconde face du substrat située du côté opposé à la première face, le fond du second trou débouchant sur la première extrémité (128) du premier cylindre.

4. Le circuit selon l'une quelconque des revendications 2 ou 3, dans lequel le substrat forme un premier substrat (290) présentant une face supérieure (294), et le circuit comporte un second substrat (288) présentant une face inférieure (292) directement assemblée sur la face supérieure du premier substrat (290) et une face supérieure (284) du côté opposé à sa face inférieure, ces premier et second substrats assemblés formant, respectivement, des première et seconde couches d'un troisième substrat (282) plus épais, ces couches s'étendant essentiellement parallèlement au plan du troisième substrat, le trou borgne de la revendication 2 ou les premier et second trous de la revendication 3 étant formés depuis la ou les faces du premier substrat, et le second substrat comportant des troisième et quatrième plots (306, 308) de contact disposés sur sa face supérieure et électriquement raccordés, respectivement, aux premier et second plots de contact.

5. Le circuit selon la revendication 1, dans lequel :
- le substrat comporte au moins une première couche (190) présentant une face supérieure et une seconde couche (188) présentant une face inférieure directement assemblée sur la face supérieure de la première couche (190), ces couches s'étendant essentiellement parallèlement au plan du substrat,
- les premier et second conducteurs électriques (196, 198 ; 262, 264) comportent, respectivement, une première et une seconde pistes conductrices (206, 220 ; 268) réalisées sur la face supérieure de la première couche (190) ou sur la face inférieure de la seconde couche (188) et s'étendant essentiellement parallèlement au plan du substrat, des extrémités distales (212, 214) de ces pistes situées entre les première et seconde couches formant, respectivement, les première et seconde extrémités enfouies des premier et second conducteurs électriques.

6. Le circuit selon la revendication 5, dans lequel les extrémités distales (212, 214) des première et seconde pistes se chevauchent l'une au-dessus de l'autre dans une direction perpendiculaire au plan du substrat.

7. Le circuit selon la revendication 5 ou 6, dans lequel les premier et second conducteurs (196, 198) comportent, respectivement, un premier et un second prolongements (210, 218) s'enfonçant à l'intérieur du substrat pour raccorder électriquement les première et seconde pistes (206, 220), respectivement, aux premier et second plots (208, 216) de contact, au moins l'un des prolongements (210, 218) étant formé par un via traversant de part en part la première ou la seconde couche.

8. Le circuit selon l'une quelconque des revendications précédentes, dans lequel la distance la plus courte entre chaque plot de contact et la jonction est au moins supérieure à 50 µm.

9. Procédé de fabrication d'un circuit intégré équipé d'une sonde de température, ce procédé comportant :
a) la fourniture (70) d'un substrat s'étendant essentiellement dans un plan appelé « plan du substrat »,
b) la réalisation (90) en surface et/ou à l'intérieur du substrat d'au moins un composant électronique du circuit intégré,
c) la réalisation (72 ; 140 ; 230), par des procédés microélectroniques, d'un premier conducteur électrique comportant un premier plot de contact en surface du substrat et une première extrémité, le premier conducteur électrique étant électriquement isolé du substrat,
d) la réalisation (72 ; 140 ; 230), par des procédés microélectroniques, d'un second conducteur électrique comportant un second plot de contact en surface du substrat et une seconde extrémité, le second conducteur électrique étant électriquement isolé du substrat et électriquement isolé du premier conducteur électrique sauf au niveau de la seconde extrémité qui est mécaniquement et électriquement directement en contact avec la première extrémité pour former une jonction électrique,
**caractérisé en ce que** lors des étapes c) et d), les première et seconde extrémités sont entièrement enfouies à au moins 5 µm de profondeur à l'intérieur du substrat et réalisées, respectivement, dans des premier et second matériaux différents choisis pour que la valeur absolue du coefficient Seebeck de la jonction soit supérieure à 1 µV/K à 20 °C de sorte que la combinaison de ces premier et second conducteurs forme la sonde de température.

10. Procédé selon la revendication 9, dans lequel les étapes c) et d) comportent la réalisation (72 ; 140) de premier et second prolongements s'enfonçant à l'intérieur du substrat pour raccorder électriquement les première et seconde extrémités, respectivement, au premier et second plots de contact, la réalisation de ces prolongements comportant :
1) la formation (74) d'un trou borgne d'au moins 5 µm de profondeur depuis une face extérieure du substrat,
2) le dépôt (82, 88) à l'intérieur du même trou d'un premier et d'un second cylindres, dont au moins les extrémités distales enfouies à l'intérieur du substrat sont réalisées, respectivement, dans les premier et second matériaux pour former, respectivement, les première et seconde extrémités enfouies des premier et second conducteurs électriques, ces premier et second cylindres s'étendant à l'intérieur du trou depuis la face extérieure du substrat jusqu'aux, respectivement, première et seconde extrémités,
3) le dépôt (84, 86) d'une couche électriquement isolante entre les premier et second cylindres sauf entre les première et seconde extrémités.

11. Procédé selon la revendication 10, dans lequel le dépôt de la couche électriquement isolante de partout entre les premier et second cylindres sauf entre les première et seconde extrémités consiste, après le dépôt du premier cylindre et avant le dépôt du second cylindre, :
- à déposer (84) la couche électriquement isolante de partout sur la face exposée à l'extérieur du premier cylindre, puis
- à éliminer (86) la couche électriquement isolante uniquement au niveau de la première extrémité.

12. Procédé selon la revendication 9, dans lequel les étapes c) et d) comportent la réalisation de premier et second prolongements s'enfonçant à l'intérieur du substrat pour raccorder électriquement les première et seconde extrémités, respectivement, aux premier et second plots de contact, la réalisation de ces prolongements comportant :
1) la formation (142) d'un premier trou de borgne d'au moins 5 µm de profondeur depuis une première face extérieure du substrat,
2) le dépôt (148) dans le premier trou borgne d'un premier cylindre, dont au moins l'extrémité distale enfouie à l'intérieur du substrat est réalisée dans le premier matériau pour former la première extrémité du premier conducteur électrique, ce premier cylindre s'étendant à l'intérieur du premier trou depuis la première face extérieure du substrat jusqu'à la première extrémité,
3) la formation (150) d'un second trou borgne d'au moins 5 µm de profondeur depuis une seconde face extérieure du substrat située d'un côté opposé à la première face, le fond de ce second trou débouchant sur la première extrémité du premier cylindre, et
4) le dépôt (158) dans le second trou borgne d'un second cylindre, dont au moins l'extrémité distale enfouie à l'intérieur du substrat est réalisée dans le second matériau pour former la seconde extrémité du second conducteur électrique, ce second cylindre s'étendant à l'intérieur du second trou depuis la seconde face extérieure du substrat jusqu'à la seconde extrémité.

13. Procédé selon l'une quelconque des revendications 10 à 12, dans lequel le substrat réalisé selon la revendication 10 ou 12 forme un premier substrat présentant une face supérieure, puis le procédé comporte :
- l'assemblage de la face supérieure du premier substrat directement sur une face inférieure d'un second substrat, ces premier et second substrats assemblés formant alors, respectivement, des première et seconde couches d'un troisième substrat plus épais, ces couches s'étendant essentiellement parallèlement au plan du troisième substrat,
- la réalisation de troisième et quatrième plots de contact sur une face supérieure du second substrat, cette face supérieure étant située du côté opposé à sa face inférieure et ces troisième et quatrième plots de contact étant électriquement raccordés, respectivement, aux premier et second plots de contact.

14. Procédé selon la revendications 9, dans lequel le procédé comporte :
- la réalisation d'une première piste conductrice sur une face supérieure d'une première couche ou sur une face inférieure d'une seconde couche,
- la réalisation d'une seconde piste conductrice sur la face supérieure de la première couche ou sur la face inférieure de la seconde couche, puis
- l'assemblage de la face supérieure de la première couche directement sur la face inférieure de la seconde couche de manière à ce que des extrémités distales des pistes situées entre les première et seconde couches forment, respectivement, les première et seconde extrémités enfouies des premier et second conducteurs électriques, ces première et seconde couches assemblées formant le substrat, ces couches s'étendant essentiellement parallèlement au plan du substrat.

## Patentansprüche

1. Integrierter Schaltkreis, umfassend:
- ein Substrat (6; 174; 282), das sich im Wesentlichen in einer Ebene erstreckt, die "Ebene des Substrats" genannt wird,
- mindestens eine elektronische Komponente (10), die im Inneren und/oder auf der Oberfläche des Substrats erstellt ist,
- einen ersten elektrischen Leiter (14; 112; 196; 262), der ein erstes Kontaktpad (30; 120; 208; 266; 306; 324) auf der Oberfläche des Substrats und ein erstes Ende (42; 128; 212) aufweist, wobei der erste elektrische Leiter von dem Substrat elektrisch isoliert ist,
- einen zweiten elektrischen Leiter (18; 198; 264), der ein zweites Kontaktpad (50; 216; 308; 326; 342) auf der Oberfläche des Substrats und ein zweites Ende (62; 214) aufweist, wobei der zweite elektrische Leiter vom Substrat elektrisch isoliert ist und von dem ersten elektrischen Leiter elektrisch isoliert ist, außer am zweiten Ende, das mechanisch und elektrisch direkt in Kontakt mit dem ersten Ende ist, um eine elektrische Verbindung (63; 200) zu bilden,
**dadurch gekennzeichnet, dass** das erste (42; 128; 212) und zweite (62; 214) Ende vollständig in mindestens 5 µm Tiefe im Inneren des Substrats eingebettet sind und jeweils in einem ersten und zweiten unterschiedlichen Material erstellt sind, die derart gewählt sind, dass der absolute Wert des Seebeck-Koeffizienten der Verbindung mehr als 1 µV/K bei 20 °C beträgt, so dass die Kombination dieses ersten und zweiten Leiters eine Temperatursonde bildet.

2. Schaltkreis nach Anspruch 1, wobei:
- der erste und zweite elektrische Leiter (14, 18) jeweils eine erste und zweite Verlängerung (32, 52) aufweisen, die ins Innere des Substrats eindringen, um das erste und zweite Ende (42, 62) jeweils mit dem ersten und zweiten Kontaktpad (30, 50) elektrisch zu verbinden, wobei diese erste und zweite Verlängerung jeweils einen ersten und einen zweiten Zylinder aufweisen, die im Inneren eines gleichen Sacklochs (40) von mindestens 5 µm Tiefe angeordnet sind, die von einer Seite des Substrats aus gebildet sind, wobei mindestens die distalen Enden des ersten und zweiten Zylinders, die im Inneren des Substrats eingebettet sind, jeweils in dem ersten und zweiten Material erstellt sind, um jeweils das erste und zweite Ende zu bilden, die in dem ersten und zweiten elektrischen Leiter eingebettet sind, wobei sich dieser erste und zweite Zylinder im Inneren des Lochs von der Seite des Substrats aus jeweils bis zu dem ersten und zweiten Ende erstrecken, und
- der integrierte Schaltkreis auch mindestens eine elektrisch isolierende Schicht (64) aufweist, die überall zwischen dem ersten und zweiten Zylinder angeordnet ist, außer zwischen dem ersten und zweiten Ende.

3. Schaltkreis nach Anspruch 1, wobei:
- der erste und zweite elektrische Leiter (18, 112) jeweils eine erste und zweite Verlängerung (52, 124) aufweisen, die ins Innere des Substrats eindringen, um das erste und zweite Ende (62, 128) jeweils mit dem ersten und zweiten Kontaktpad (50, 120) elektrisch zu verbinden,
- die erste Verlängerung (124) einen ersten Zylinder aufweist, von dem mindestens das distale Ende, das im Inneren des Substrats eingebettet ist, in dem ersten Material erstellt ist, um das erste Ende (128) des ersten elektrischen Leiters zu bilden, wobei sich dieser erste Zylinder im Inneren eines ersten Lochs (130), das von einer ersten Seite des Substrats aus gebildet ist, jeweils bis zu dem ersten Ende erstreckt,
- die zweite Verlängerung (52) einen zweiten Zylinder aufweist, von dem mindestens das distale Ende, das in dem Substrat eingebettet ist, in dem zweiten Material erstellt ist, um das zweite Ende (62) des zweiten elektrischen Leiters zu bilden, wobei sich der zweite Zylinder im Inneren eines zweiten Lochs (40) bis zu dem zweiten Ende (62) erstreckt, wobei das zweite Loch von einer zweiten Seite des Substrats aus gebildet ist, die auf der Seite angeordnet ist, die der ersten Seite gegenüberliegt, wobei der Boden des zweiten Lochs zu dem ersten Ende (128) des ersten Zylinders führt.

4. Schaltkreis nach einem der Ansprüche 2 oder 3, wobei das Substrat ein erstes Substrat (290) bildet, das eine obere Seite (294) aufweist, und der Schaltkreis ein zweites Substrat (288) aufweist, das eine untere Seite (292), die direkt auf der oberen Seite des ersten Substrats (290) angebracht ist, und eine obere Seite (284) auf der Seite, die seiner unteren Seite gegenüberliegt, aufweist, wobei dieses erste und zweite zusammengesetzte Substrat jeweils eine erste und zweite Schicht eines dritten, dickeren Substrats (282) bilden, wobei sich diese Schichten im Wesentlichen parallel zu der Ebene des dritten Substrats erstrecken, wobei das Sackloch des Anspruchs 2 oder das erste und zweite Loch des Anspruchs 3 von der oder den Seiten des ersten Substrats aus gebildet sind, und wobei das zweite Substrat ein drittes und viertes Kontaktpad (306, 308) aufweist, die auf seiner oberen Seite angeordnet sind und jeweils mit dem ersten und zweiten Kontaktpad elektrisch verbunden sind.

5. Schaltkreis nach Anspruch 1, wobei:
- das Substrat mindestens eine erste Schicht (190), die eine obere Seite aufweist, und eine zweite Schicht (188), die eine untere Seite aufweist, die direkt auf der oberen Seite der ersten Schicht (190) angeordnet ist, aufweist, wobei sich diese Schichten im Wesentlichen parallel zu der Ebene des Substrats erstrecken,
- der erste und zweite elektrische Leiter (196, 198; 262, 264) jeweils eine erste und eine zweite Leiterbahn (206, 220; 268) aufweisen, die auf der oberen Seite der ersten Schicht (190) oder auf der unteren Seite der zweiten Schicht (188) erstellt sind, und sich im Wesentlichen parallel zu der Ebene des Substrats erstrecken, wobei die distalen Enden (212, 214) dieser Leiterbahnen, die zwischen der ersten und zweiten Schicht angeordnet sind, jeweils das erste und zweite eingebettete Ende des ersten und zweiten elektrischen Leiters bilden.

6. Schaltkreis nach Anspruch 5, wobei die distalen Enden (212, 214) der ersten und zweiten Leiterbahn einander in einer Richtung senkrecht zur Ebene des Substrats überlappen.

7. Schaltkreis nach Anspruch 5 oder 6, wobei der erste und zweite Leiter (196, 198) jeweils eine erste und zweite Verlängerung (210, 218) aufweisen, die ins Innere des Substrats eindringen, um die erste und zweite Leiterbahn (206, 220) jeweils mit dem ersten und zweiten Kontaktpad (208, 216) elektrisch zu verbinden, wobei mindestens die eine der Verlängerungen (210, 218) aus einer VIA gebildet ist, die die erste oder die zweite Schicht durchgehend durchquert.

8. Schaltkreis nach einem der vorhergehenden Ansprüche, wobei der kürzeste Abstand zwischen jedem Kontaktpad und der Verbindung mindestens größer als 50 µm ist.

9. Herstellungsverfahren eines integrierten Schaltkreises, der mit einer Temperatursonde ausgestattet ist, wobei das Verfahren umfasst:
a) das Bereitstellen (70) eines Substrats, das sich im Wesentlichen in einer Ebene erstreckt, die "Ebene des Substrats" genannt wird,
b) das Erstellen (90) mindestens einer elektronischen Komponente des integrierten Schaltkreises auf der Oberfläche und/oder im Inneren des Substrats,
c) das Erstellen (72; 140; 230) durch mikroelektronische Verfahren eines ersten elektrischen Leiters, der ein erstes Kontaktpad auf der Oberfläche des Substrats und ein erstes Ende aufweist, wobei der erste elektrische Leiter von dem Substrat elektrisch isoliert ist,
d) das Erstellen (72; 140; 230) durch mikroelektronische Verfahren eines zweiten elektrischen Leiters, der ein zweites Kontaktpad auf der Oberfläche des Substrats und ein zweites Ende aufweist, wobei der zweite elektrische Leiter vom Substrat elektrisch isoliert ist und von dem ersten elektrischen Leiter elektrisch isoliert ist, außer am zweiten Ende, das mechanisch und elektrisch direkt in Kontakt mit dem ersten Ende ist, um eine elektrische Verbindung zu bilden,
**dadurch gekennzeichnet, dass** das erste und zweite Ende während der Schritte c) und d) vollständig in mindestens 5 µm Tiefe im Inneren des Substrats eingebettet sind und jeweils in einem ersten und zweiten unterschiedlichen Material erstellt sind, die derart gewählt sind, dass der absolute Wert des Seebeck-Koeffizienten der Verbindung mehr als 1 µV/K bei 20 °C beträgt, so dass die Kombination dieses ersten und zweiten Leiters eine Temperatursonde bildet.

10. Verfahren nach Anspruch 9, wobei die Schritte c) und d) das Erstellen (72; 140) einer ersten und zweiten Verlängerung aufweisen, die ins Innere des Substrats eindringen, um das erste und zweite Ende jeweils mit dem ersten und zweiten Kontaktpad elektrisch zu verbinden, wobei das Erstellen dieser Verlängerungen Folgendes aufweist:
1) das Bilden (74) eines Sacklochs von mindestens 5 µm Tiefe von einer äußeren Seite des Substrats aus,
2) das Aufbringen (82, 88) im Inneren desselben Lochs eines ersten und eines zweiten Zylinders, von denen mindestens die distalen Enden, die im Inneren des Substrats eingebettet sind, jeweils in dem ersten und zweiten Material erstellt werden, um jeweils das erste und zweite eingebettete Ende des ersten und zweiten elektrischen Leiters zu bilden, wobei sich dieser erste und zweite Zylinder im Inneren des Lochs von der äußeren Seite des Substrats aus jeweils bis zum ersten und zweiten Ende erstrecken,
3) das Aufbringen (84, 86) einer elektrisch isolierenden Schicht zwischen dem ersten und zweiten Zylinder, außer zwischen dem ersten und zweiten Ende.

11. Verfahren nach Anspruch 10, wobei das Aufbringen der elektrisch isolierenden Schicht überall zwischen dem ersten und zweiten Zylinder, außer zwischen dem ersten und zweiten Ende nach dem Aufbringen des ersten Zylinders und vor dem Aufbringen des zweiten Zylinders darin besteht:
- die elektrisch isolierende Schicht überall auf der Seite aufzubringen (84), die zur Außenseite des Zylinders freiliegt, und dann
- die elektrisch isolierende Schicht nur an dem ersten Ende zu entfernen (86).

12. Verfahren nach Anspruch 9, wobei die Schritte c) und d) das Erstellen einer ersten und zweiten Verlängerung aufweisen, die ins Innere des Substrats eindringen, um das erste und zweite Ende jeweils mit dem ersten und zweiten Kontaktpad elektrisch zu verbinden, wobei das Erstellen dieser Verlängerungen Folgendes aufweist:
1) das Bilden (142) eines ersten Sacklochs von mindestens 5 µm Tiefe von einer ersten äußeren Seite des Substrats aus,
2) das Aufbringen (148) in dem ersten Sackloch eines ersten Zylinders, von dem mindestens das distale Ende, das im Inneren des Substrats eingebettet ist, in dem ersten Material erstellt wird, um das erste Ende des ersten elektrischen Leiters zu bilden, wobei sich dieser erste Zylinder im Inneren des ersten Lochs von der ersten äußeren Seite des Substrats aus bis zu dem ersten Ende erstreckt,
3) das Bilden (150) eines zweiten Sacklochs von mindestens 5 µm Tiefe von einer zweiten äußeren Seite des Substrats aus, die auf einer Seite angeordnet ist, die der ersten Seite gegenüberliegt, wobei der Boden dieses zweiten Lochs zu dem ersten Ende des ersten Zylinders führt, und
4) das Aufbringen (158) in dem zweiten Sackloch eines zweiten Zylinders, von dem mindestens das distale Ende, das im Inneren des Substrats eingebettet ist, in dem zweiten Material erstellt wird, um das zweite Ende des zweiten elektrischen Leiters zu bilden, wobei sich dieser zweite Zylinder im Inneren des zweiten Lochs von der zweiten äußeren Seite des Substrats aus bis zu dem zweiten Ende erstreckt.

13. Verfahren nach einem der Ansprüche 10 bis 12, wobei das Substrat, das nach dem Anspruch 10 oder 12 erstellt wird, ein erstes Substrat bildet, das eine obere Seite aufweist, und das Verfahren dann Folgendes aufweist:
- das Zusammensetzen der oberen Seite des ersten Substrats direkt auf einer unteren Seite eines zweiten Substrats, wobei dieses erste und zweite zusammengesetzte Substrat dann jeweils eine erste und zweite Schicht eines dritten, dickeren Substrats bilden, wobei sich diese Schichten im Wesentlichen parallel zu der Ebene des dritten Substrats erstrecken,
- das Erstellen eines dritten und vierten Kontaktpads auf einer oberen Seite des zweiten Substrats, wobei diese obere Seite auf der Seite, die seiner unteren Seite gegenüberliegt, angeordnet ist, und wobei dieses dritte und vierte Kontaktpad jeweils mit dem ersten und zweiten Kontaktpad elektrisch verbunden sind.

14. Verfahren nach Anspruch 9, wobei das Verfahren Folgendes aufweist:
- das Erstellen einer ersten Leiterbahn auf einer oberen Seite einer ersten Schicht oder auf einer unteren Seite einer zweiten Schicht,
- das Erstellen einer zweiten Leiterbahn auf der oberen Seite der ersten Schicht oder auf der unteren Seite der zweiten Schicht, und dann
- das Zusammensetzen der oberen Seite der ersten Schicht direkt auf der unteren Seite der zweiten Schicht, so dass die distalen Enden der Leiterbahnen, die zwischen der ersten und zweiten Schicht angeordnet sind, jeweils das erste und zweite Ende bilden, die in dem ersten und zweiten elektrischen Leiter eingebettet sind, wobei diese erste und zweite zusammengesetzte Schicht das Substrat bilden, wobei sich diese Schichten im Wesentlichen parallel zu der Ebene des Substrats erstrecken.

## Claims

1. Integrated circuit comprising:
- a substrate (6; 174; 282) extending essentially in a plane called "plane of the substrate",
- at least one electronic component (10) produced inside and/or on the surface of the substrate,
- a first electrical conductor (14; 112; 196; 262) comprising a first bump contact (30; 120; 208; 266; 306; 324) on the surface of the substrate and a first end (42; 128; 212), the first electrical conductor being electrically insulated from the substrate,
- a second electrical conductor (18; 198; 264) comprising a second bump contact (50; 216; 308; 326; 342) on the surface of the substrate and a second end (62; 214), the second electrical conductor being electrically insulated from the substrate and electrically insulated from the first electrical conductor except at the second end which is mechanically and electrically directly in contact with the first end to form an electrical junction (63; 200), charactized in that the first (42; 128; 212) and second (62; 214) ends are entirely buried to at least 5 µm depth inside the substrate and produced, respectively, in different first and second materials chosen for the absolute value of the Seebeck coefficient of the junction to be greater than 1 µV/K at 20°C such that the combination of these first and second conductors forms a temperature probe.

2. Circuit according to Claim 1, in which:
- the first and second electrical conductors (14, 18) comprise, respectively, first and second extensions (32, 52) driven into the substrate to electrically connect the first and second ends (42, 62), respectively, to the first and second bump contacts (30, 50), these first and second extensions comprising, respectively, a first and a second cylinders arranged inside one and the same blind via (40) at least 5 µm deep formed from a face of the substrate, at least the distal ends buried inside the substrate of the first and second cylinders being produced, respectively, in the first and second materials to form, respectively, the first and second buried ends of the first and second electrical conductors, these first and second cylinders extending inside the via from the face of the substrate to, respectively, the first and second ends, and
- the integrated circuit also comprises at least a layer of electrical insulator situated everywhere between the first and second cylinders except between the first and second ends.

3. Circuit according to Claim 1, in which:
- the first and second electrical conductors (18, 112) comprise, respectively, first and second extensions (52, 124) driven into the substrate to electrically connect the first and second ends (62, 128), respectively, to the first and second bump contacts (50, 120),
- the first extension (124) comprising a first cylinder, at least the distal end of which buried inside the substrate is produced in the first material to form the first end (128) of the first electrical conductor, this first cylinder extending inside a first via (130) formed from a first face of the substrate to the first end,
- the second extension (52) comprising a second cylinder, at least the distal end of which, buried inside the substrate, is produced in the second material to form the second end (62) of the second electrical conductor, this second cylinder extending inside a second via (40) to the second end (62), this second via being formed from a second face of the substrate situated on the side opposite the first face, the bottom of the second via emerging on the first end (128) of the first cylinder.

4. Circuit according to either of Claims 2 and 3, in which the substrate forms a first substrate (290) having a top face (294), and the circuit comprises a second substrate (288) having a bottom face (292) directly joined to the top face of the first substrate (290) and a top face (284) on the side opposite its bottom face, these first and second substrates joined together forming, respectively, first and second layers of a third, thicker substrate (282), these layers extending essentially parallel to the plane of the third substrate, the blind via of Claim 2 or the first and second vias of Claim 3 being formed from the face or faces of the first substrate, and the second substrate comprising third and fourth bump contacts (306, 308) arranged on its top face and electrically connected, respectively, to the first and second bump contacts.

5. Circuit according to Claim 1, in which:
- the substrate comprises at least one first layer (190) having a top face and one second layer (188) having a bottom face, assembled directly on the top face of the first layer (190), these layers extending essentially parallel to the plane of the substrate,
- the first and second electrical conductors (196, 198; 262, 264) comprise, respectively, a first and a second conductive tracks (206, 220; 268) produced on the top face of the first layer (190) or on the bottom face of the second layer (188) and extending essentially parallel to the plane of the substrate, distal ends (212, 214) of these tracks situated between the first and second layers forming, respectively, the buried first and second ends of the first and second electrical conductors.

6. Circuit according to Claim 5, in which the distal ends (212, 214) of the first and second tracks overlap one another in a direction at right angles to the plane of the substrate.

7. Circuit according to Claim 5 or 6, in which the first and second conductors (196, 198) comprise, respectively, a first and a second extensions (210, 218) driven into the substrate to electrically connect the first and second tracks (206, 220), respectively, to the first and second bump contacts (208, 216), at least one of the extensions (210, 218) being formed by a via passing right through the first or the second layer.

8. Circuit according to any one of the preceding claims, in which the shortest distance between each bump contact and the junction is at least greater than 50 µm.

9. Method for fabricating an integrated circuit equipped with a temperature probe, this method comprising:
a) the supply (70) of a substrate extending essentially in a plane called "plane of the substrate",
b) the production (90) on the surface and/or inside the substrate of at least one electronic component of the integrated circuit,
c) the production (72; 140; 230), by microelectronics methods, of a first electrical conductor comprising a first bump contact on the surface of the substrate and a first end, the first electrical conductor being electrically insulated from the substrate,
d) the production (72; 140; 230), by microelectronics methods, of a second electrical conductor comprising a second bump contact on the surface of the substrate and a second end, the second electrical conductor being electrically insulated from the substrate and electrically insulated from the first electrical conductor except at the second end which is mechanically and electrically directly in contact with the first end to form an electrical junction, **characterized in that**, in the steps c) and d), the first and second ends are entirely buried to at least 5 µm depth inside the substrate and produced, respectively, in different first and second materials chosen for the absolute value of the Seebeck coefficient of the junction to be greater than 1 µV/K at 20°C such that the combination of these first and second conductors forms the temperature probe.

10. Method according to Claim 9, in which the steps c) and d) comprise the production (72; 140) of first and second extensions, driven into the substrate to electrically connect the first and second ends, respectively, to the first and second bump contacts, the production of these extensions comprising:
1) the formation (74) of a blind via at least 5 µm deep from an outer face of the substrate,
2) the deposition (82, 88) inside the same via of a first and a second cylinders of which at least the distal ends buried inside the substrate are produced, respectively, in the first and second materials to form, respectively, the buried first and second ends of the first and second electrical conductors, these first and second cylinders extending inside the via from the outer face of the substrate to, respectively, first and second ends,
3) the deposition (84, 86) of an electrically insulating layer between the first and second cylinders except between the first and second ends.

11. Method according to Claim 10, in which the deposition of the electrically insulating layer everywhere between the first and second cylinders except between the first and second ends consists, after the deposition of the first cylinder and before the deposition of the second cylinder:
- in depositing (84) the electrically insulating layer everywhere on the face exposed to the outside of the first cylinder, then
- in eliminating (86) the electrically insulating layer at the first end only.

12. Method according to Claim 9, in which the steps c) and d) comprise the production of first and second extensions driven into the substrate to electrically connect the first and second ends, respectively, to the first and second bump contacts, the production of these extensions comprising:
1) the formation (142) of a first blind via of at least 5 µm depth from a first outer face of the substrate,
2) the deposition (148) in the first blind via of a first cylinder, of which at least the distal end buried inside the substrate is produced in the first material to form the first end of the first electrical conductor, this first cylinder extending inside the first via from the first outer face of the substrate to the first end,
3) the formation (150) of a second blind via of at least 5 µm depth from a second outer face of the substrate situated on a side opposite the first face, the bottom of this second via emerging on the first end of the first cylinder, and
4) the deposition (158) in the second blind via of a second cylinder, of which at least the distal end buried inside the substrate is produced in the second material to form the second end of the second electrical conductor, this second cylinder extending inside the second via from the second outer face of the substrate to the second end.

13. Method according to any one of Claims 10 to 12, in which the substrate produced according to Claim 10 or 12 forms a first substrate having a top face, then the method comprises:
- the assembly of the top face of the first substrate directly on a bottom face of a second substrate, these assembled first and second substrates then forming, respectively, first and second layers of a third, thicker substrate, these layers extending essentially parallel to the plane of the third substrate,
- the production of third and fourth bump contacts on a top face of the second substrate, this top face being situated on the side opposite its bottom face and these third and fourth bump contacts being electrically connected, respectively, to the first and second bump contacts.

14. Method according to Claim 9, in which the method comprises:
- the production of a first conductive track on a top face of a first layer or on a bottom face of a second layer,
- the production of a second conductive track on the top face of the first layer or on the bottom face of the second layer, then
- the assembly of the top face of the first layer directly on the bottom face of the second layer in such a way that the distal ends of the tracks situated between the first and second layers form, respectively, the buried first and second ends of the first and second electrical conductors, these assembled first and second layers forming the substrate, these layers extending essentially parallel to the plane of the substrate.
